# EUROPEAN PATENT APPLICATION

(11) **EP 2 669 588 A1**
(43) Date of publication of application: **04.12.2013**
(21) Application number: 11856757.7
(22) Date of filing: 06.12.2011
(51) Int. Cl.: F24F 11/02

(54) **AIR CONDITIONING SYSTEM AND START-UP CONTROL METHOD THEREFOR**

(30) Priority: 25.01.2011 JP 2011012848
(71) Applicant: Daikin Industries, Ltd., Osaka-shi, Osaka 530-8323 (JP)
(72) Inventor: WADA, Kunihide, Sakai-shi Osaka 591-8511 (JP); ISHIKAWA, Tatsuya, Sakai-shi Osaka 591-8511 (JP)
(74) Representative: HOFFMANN EITLE
(86) International application number: PCT/JP2011/078120
(87) International publication number: WO 2012/101902

(57) **Abstract**

An air conditioning system (10) includes a plurality of air conditioners (12) to which electric power is supplied from the same power supply (14), temperature detection sensors (29) for respectively detecting interior temperatures in air conditioning regions corresponding to the air conditioners (12), a temperature storage section (33) for storing control temperatures of the plurality of air conditioners (12) and the interior temperatures detected by the temperature detection sensors (29), a power restoration detection section (34) for detecting that power supply is restored after power interruption, and an initiation timing setting section (35) for, in a case where the power restoration is detected by the power restoration detection section (34), comparing the control temperatures stored in the temperature storage section (33) respectively for the plurality of air conditioners (12) with the interior temperatures detected after the power restoration or before the power interruption by the temperature detection sensors (29) and stored in the temperature storage section (33), and setting initiation timings of the air conditioners (12) in such a manner that the air conditioner (12) corresponding to the air conditioning region having a larger air conditioning load based on a difference between the temperatures is initiated earlier.

## Description

### TECHNICAL FIELD

The present invention relates to an air conditioning system and an initiation control method of the same.

### BACKGROUND ART

In a data center where a large number of computer devices such as a server computer are housed, air conditioning devices are fully equipped for preventing a room temperature increase due to heat generation from the computer devices. For example, a plurality of racks for installing the computer devices is provided in line in an interior of the data center, and a plurality of air conditioners is separately installed in accordance with arrangement of the racks, a flow of heat, and the like.

In a case where power interruption is generated in such a data center, operations of the computer devices would be maintained by an uninterruptible power supply system or an in-house power generator. However, since power supply is normally interrupted regarding the air conditioners, a temperature in the interior is radically increased. Therefore, after restoration from the power interruption, the air conditioners are automatically restarted, so that the interior is quickly cooled down.

However, when the plurality of air conditioners is restarted at the same time, a peak current is radically elevated. Thus, there is a disadvantage that a load is concentrated on power supply devices. Therefore, conventionally, an initiation order of the plurality of air conditioners is preliminarily set, and when the power supply is restored after the power interruption, the plurality of air conditioners is initiated one by one in the above order.

It should be noted that Patent Literature 1 described below discloses a technique, although which is different from initiation control at the time of power restoration, for differentiating initiation start times of a plurality of air conditioners in a cooling and heating system including the plurality of air conditioners.

### CITATION LIST

### [PATENT LITERATURE]

Patent Literature 1: Japanese Patent No. 2994940

### SUMMARY OF INVENTION

### TECHNICAL PROBLEM

The computer devices are not always evenly arranged in the plurality of racks provided in line in the data center. However, there is sometimes a case where the computer devices are arranged concentratedly on a particular rack. In this case, a temperature increase is remarkable in a particular region in the interior where the computer devices are concentrated, so that unevenness is generated in a temperature distribution in the interior. Therefore, when the air conditioners are initiated in the preliminarily set order upon the power restoration after the power interruption, there is sometimes a case where the particular region where the temperature increase is remarkable cannot be promptly and efficiently cooled down.

The present invention is achieved in consideration with the above situation, and an object thereof is to provide an air conditioning system capable of efficiently performing room temperature control when power supply is restored after power interruption, and an initiation control method of the same.

### SOLUTION TO PROBLEM

An air conditioning system according to a first aspect of the present invention is
an air conditioning system including a plurality of air conditioners to which electric power is supplied from the same power supply, the air conditioning system including
temperature detection sensors for respectively detecting interior temperatures in air conditioning regions corresponding to the air conditioners,
a temperature storage section for storing control temperatures of the plurality of air conditioners and the interior temperatures detected by the temperature detection sensors,
a power restoration detection section for detecting that power supply is restored after power interruption, and
an initiation timing setting section for, in a case where the power restoration is detected by the power restoration detection section, comparing the control temperatures stored in the temperature storage section respectively for the plurality of air conditioners with the interior temperatures detected after the power restoration or before the power interruption by the temperature detection sensors and stored in the temperature storage section, and setting initiation timings of the air conditioners in such a manner that the air conditioner corresponding to the air conditioning region having a larger air conditioning load based on a difference between the temperatures is initiated earlier.

According to the air conditioning system of the present invention, in a case where the power supply is restored after the power interruption, the air conditioner corresponding to the air conditioning region having a larger air conditioning load based on the difference between the control temperature and the interior temperature can be promptly initiated. Thus, temperature control of the air conditioning region can be efficiently performed.
It should be noted that the air conditioners of the present invention are formed so that one air conditioner includes one or a plurality of compressors forming one or a plurality of refrigerant circuits. For example, in a case where a plurality of indoor units is operated by a common compressor, the plurality of indoor units forms one air conditioner.

The temperature detection sensor may be integrated with the air conditioner.
In this case, the temperature detection sensor preliminarily provided in the air conditioner can be utilized for setting the initiation timing of the air conditioner after the power restoration.

The temperature detection sensor may be provided in the air conditioning region corresponding to the air conditioner as a separate body from the air conditioner.
In this case, the temperature detection sensor can be provided corresponding to a place where a temperature change is remarkable such as a peripheral part of a heating element installed in an interior. Thus, the initiation order can be more efficiently set.

The power restoration detection section, the temperature storage section, and the initiation timing setting section are provided in each of the plurality of air conditioners.
With the above configuration, each of the air conditioners can independently and properly set the initiation timing. Therefore, there is no need for providing a device for performing adjustment between the initiation timings of the air conditioners, so that the air conditioning system can be inexpensively and simply formed.

The air conditioning system may further include a central control device having the power restoration detection section, the temperature storage section, and the initiation timing setting section. The central control device and the air conditioners may be connected so as to communicate with each other.
With such a configuration, for example, control that the central control device adjusts and sets the initiation timings of the air conditioners so that the initiation timings are not overlapped can be realized.

An initiation control method of an air conditioning system according to a second aspect of the present invention is
an initiation control method of an air conditioning system including a plurality of air conditioners to which electric power is supplied from the same power supply, wherein
in a case where power supply is restored after power interruption, control temperatures of the air conditioners are compared with interior temperatures after the power restoration or before the power interruption in air conditioning regions corresponding to the air conditioners, and the air conditioner corresponding to the air conditioning region having a larger air conditioning load based on a difference between the temperatures is initiated earlier.

With such a configuration, when the power supply is restored after the power interruption, the air conditioner corresponding to the air conditioning region having a larger difference between the control temperature and the interior temperature can be promptly initiated. Thus, temperature control of the air conditioning region can be efficiently performed.

### ADVANTAGEOUS EFFECT OF INVENTION

According to the present invention, efficient room temperature control can be executed when the power supply is restored after the power interruption.

### BRIEF DESCRIPTION OF DRAWINGS

[FIG. 1] FIG. 1 is a configuration diagram schematically showing an air conditioning system according to a first embodiment of the present invention.
[FIG. 2] FIG. 2 is a diagram showing a refrigerant circuit of an air conditioner.
[FIG. 3] FIG. 3 is a block diagram showing a configuration of a control device.
[FIG. 4] FIG. 4 is a table used for setting a delay time.
[FIG. 5] FIG. 5 is a table for illustrating setting of initiation timings of a plurality of air conditioners.
[FIG. 6] FIG. 6 is a schematic configuration diagram of an air conditioning system according to a second embodiment of the present invention.
[FIG. 7] FIG. 7 is a block diagram showing a configuration of a central control device.
[FIG. 8] FIG. 8 is a schematic configuration diagram of an air conditioning system according to a third embodiment of the present invention.

### DESCRIPTION OF EMBODIMENTS

### [First Embodiment]

Hereinafter, embodiments of the present invention will be described with reference to the drawings.

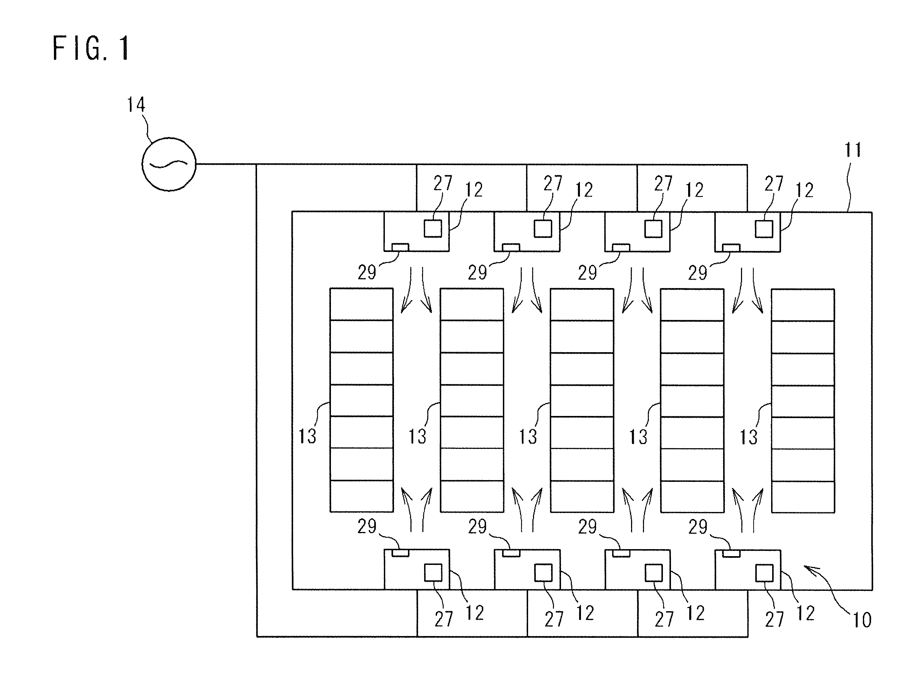

FIG. 1 is a configuration diagram schematically showing an air conditioning system according to a first embodiment of the present invention. An air conditioning system 10 includes a plurality of air conditioners 12 installed in one room 11. This room 11 is, for example, a data center where a large number of computer devices such as a server computer and a network device are installed, and in an interior thereof, a plurality of racks 13 for installing the computer devices is provided in line. The plurality of air conditioners 12 is separately arranged in the room 11 so as to efficiently suppress a temperature increase in the interior due to heat generation of the computer devices installed in the racks 13. Electric power is supplied to the plurality of air conditioners 12 from a common commercial power supply 14.

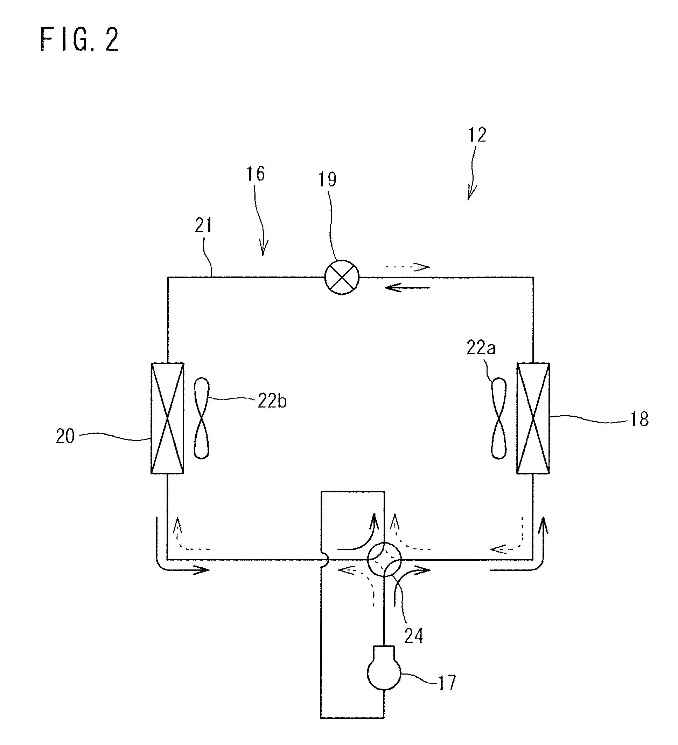

FIG. 2 is a diagram showing a refrigerant circuit of the air conditioner. The air conditioner 12 includes a heat pump type refrigerant circuit 16. The refrigerant circuit 16 includes a compressor 17 for compressing a refrigerant and generating a high-temperature and high-pressure gas refrigerant, an outdoor heat exchanger 18 serving as a condenser at the time of a cooling operation, an electromagnetic expansion valve (expansion means) 19 for reducing pressure of the refrigerant, an indoor heat exchanger 20 serving as an evaporator at the time of the cooling operation, and a refrigerant pipe 21 successively connecting these elements. Fans 22a, 22b are respectively provided in the outdoor heat exchanger 18 and the indoor heat exchanger 20 so as to face the outdoor heat exchanger 18 and the indoor heat exchanger 20.

A four way switching valve (switch means) 24 is provided in the refrigerant pipe 21. By switching the four way switching valve 24, a flow of the refrigerant is reversed, and the refrigerant discharged from the compressor 17 is switched and supplied to the outdoor heat exchanger 18 or the indoor heat exchanger 20, so that an operation is switched between the cooling operation and a heating operation.

In other words, at the time of the cooling operation, by switching the four way switching valve 24 as shown by solid lines, the refrigerant flows in the direction shown by solid arrows, the refrigerant discharged from the compressor 17 is supplied to the outdoor heat exchanger 18, and the refrigerant passing through the expansion valve 19 is supplied to the indoor heat exchanger 20. Thereby, the outdoor heat exchanger 18 serves as the condenser so as to condense and liquefy a high-temperature and high-pressure gas refrigerant, and the indoor heat exchanger 20 serves as the evaporator so as to evaporate and gasify a low-temperature and low-pressure liquid refrigerant. Further, by feeding air cooled down by heat exchange with the indoor heat exchanger 20 to the interior of the room 11, the cooling operation is performed.

At the time of the heating operation, by switching the four way switching valve 24 as shown by dotted lines, the flow of the refrigerant is reversed, and by making the refrigerant flow in the direction shown by dotted arrows, the indoor heat exchanger 20 serves as the condenser and the outdoor heat exchanger 18 serves as the evaporator. Then by feeding air heated by heat exchange with the indoor heat exchanger 20 to the interior of the room 11, the heating operation is performed. It should be noted that in a case where only the cooling operation or the heating operation is performed by the air conditioner 12, the four way switching valve 24 can be omitted, so that the flow of the refrigerant can be fixed in one direction.

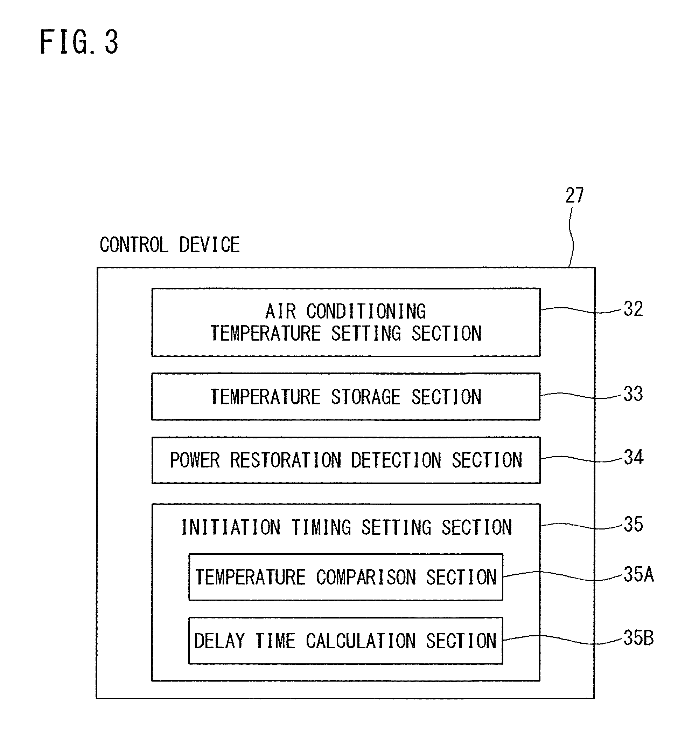

Operations of the expansion valve 19, the four way switching valve 24, the compressor 17, and the fans 22a, 22b are controlled by a control device 27 (refer to FIGS. 1 and 3) in accordance with turning ON/OFF of an operation switch and outputs of a temperature sensor or the like. The control device 27 has a microcomputer including a CPU and memories such as a RAM and a ROM, and the CPU executes programs stored in the memories so as to realize various functions.

Further, as shown in FIG. 1, the air conditioner 12 includes a temperature detection sensor 29 for detecting a temperature in the interior, and detection information of the temperature detection sensor 29 is inputted to the control device 27. Accordingly, the control device 27 controls the entire air conditioner 12 based on various input information and the like including the detection information of the temperature detection sensor 29.

The control device 27 of the present embodiment has a function of, when power supply is restored (power restoration) after supply of the electric power to the air conditioner 12 is blocked due to generation of power interruption, by automatically initiating (restarting) the air conditioner 12, returning to an operation state before the power interruption, so as to suppress the temperature increase of the room 11. Hereinafter, this function will be described in detail.

Upon the power restoration after the power interruption, when the plurality of air conditioners 12 is initiated at the same time, a peak current is increased, and a load is concentrated on power supply devices. Thus, there is a fear that a breaker is activated. Therefore, the control device 27 of the present embodiment has a function of properly setting an initiation timing of the relevant air conditioner 12 so that the initiation timing is not overlapped with initiation timings of other air conditioners 12 (initiation timing setting function).

FIG. 3 is a block diagram showing a configuration of the control device. The control device 27 includes an air conditioning temperature setting section 32, a temperature storage section 33, a power restoration detection section 34, and an initiation timing setting section 35 in order to realize the initiation timing setting function. The air conditioning temperature setting section 32 has a function of setting a target temperature (control temperature) of the room 11 via an operation unit (remote controller) which is not shown in the figure (function of receiving and storing settings in the temperature storage section 33). The temperature storage section 33 has a function of storing the control temperature set in the air conditioning temperature setting section 32 and the temperature detected by the temperature detection sensor 29.

The power restoration detection section 34 has a function of detecting that the power supply is restored after the power interruption. Specifically, the power restoration detection section 34 determines, when the air conditioner 12 is stopped, whether or not the stoppage is caused due to the power interruption. In a case where the power restoration detection section 34 determines that the stoppage is caused due to the power interruption, power supply activated after that is determined as power restoration after the power interruption. For example, the power restoration detection section 34 always monitors whether or not the compressor 17 of the air conditioner 12 is activated and in a case where the compressor 17 is activated, stores the state (compressor ON) in the memory. When the power supply is activated after the air conditioner 12 is stopped, the power restoration detection section 34 reads out the state of the compressor 17 stored in the memory. In a case where the state is the compressor ON state, the power restoration detection section can determine that the air conditioner 12 is abnormally stopped due to the power interruption and the power supply is activated by the power restoration after that.

The initiation timing setting section 35 sets the initiation timing of the air conditioner 12 in a case where the power restoration after the power interruption is detected by the power restoration detection section 34. Specifically, the initiation timing setting section 35 has a temperature comparison section 35A and a delay time calculation section 35B. The temperature comparison section 35A compares the control temperature stored in the temperature storage section 33 with an interior temperature detected by the temperature detection sensor 29 after the power restoration and stored in the temperature storage section 33, and determines a temperature difference between both the temperatures. The more the temperature difference increases, the larger an air conditioning load becomes, so that prompt initiation of the air conditioner 12 is required. It should be noted that the "temperature difference increase" indicates that the interior temperature positively increases with respect to the control temperature at the time of the cooling operation, and the interior temperature negatively increases with respect to the control temperature at the time of the heating operation.

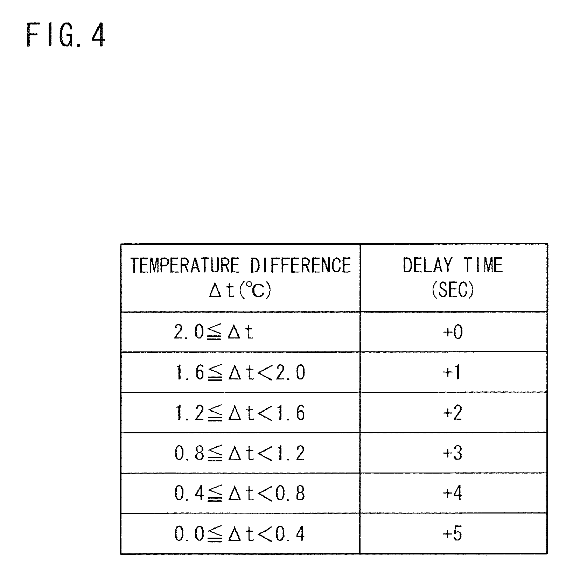

The delay time calculation section 35B determines a delay time after the power restoration until an operation of the air conditioner 12 is initiated (compressor 17 is initiated) based on the temperature difference between the control temperature and the interior temperature. For example, a table used for setting the delay time as shown in FIG. 4 is stored in the memory of the control device 27. In this table, a temperature difference Δt between the control temperature and the interior temperature and the delay time are stored in correspondence with each other. In the example of FIG. 4, in a case where the temperature difference Δt between the control temperature and the interior temperature is more than 2.0°C, the delay time is 0 seconds, and in a case where the temperature difference Δt is not more than 2.0°C but more than 1.6°C, the delay time is 1 second. Then, every time the temperature difference Δt decreases by 0.4°C, the delay time increases by 1 second.

Therefore, the larger the temperature difference Δt between the control temperature and the interior temperature is (the larger the air conditioning load is), the more the delay time is shortened, so that the air conditioner 12 is more promptly initiated. Thus, prompt room temperature control can be performed in the region where air conditioning is more required in the interior of the room 11.

The control device 27 of each of the air conditioners 12 independently executes initiation timing setting after the power restoration. Thus, there is no need for a device for performing adjustment and management between the air conditioners 12 for the initiation timing setting, so that the air conditioning system 10 can be inexpensively and simply formed.

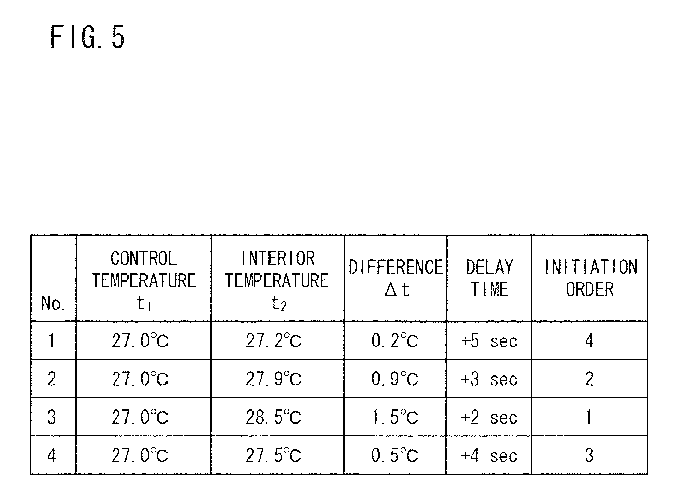

FIG. 5 shows an example that the initiation order of the plurality of air conditioners 12 is determined by using the table shown in FIG. 4. Regarding four air conditioners 12 No.1 to No.4, interior temperatures t₂ at the time of the cooling operation were detected and the initiation order was determined based on temperature differences Δt between the interior temperatures and control temperatures t₁. The control temperatures t₁ of the air conditioners 12 No.1 to No.4 are the same 27.0°C. The interior temperatures t₂ after the power restoration are 27.2°C, 27.9°C, 28.5°C, and 27.5°C, respectively. The temperature differences Δt between the interior temperatures and the control temperatures t₁ are 0.2°C, 0.9°C, 1.5°C, and 0.5°C. Referring to the table of FIG. 4, delay times are respectively determined, and the initiation order of the plurality of air conditioners 12 is set according to this delay times.

It should be noted that the table shown in FIG. 4 is only an example, and a numerical range of the temperature difference Δt and the delay time can be appropriately set in accordance with a use environment of the air conditioners 12 or the like. For example, with FIG. 4, in a case where there is the plurality of air conditioners 12 whose temperature difference Δt is more than 2°C, these air conditioners are initiated at the same time. However, in order not to cause such a situation, the entire setting range of the temperature difference Δt can be extended more or the temperatures in the entire setting range can be set to be more finely divided. For example, the entire setting range of the temperature difference Δt from 0°C to 2°C can be extended as a range from 0°C to 10°C, or the temperatures in the entire setting range divided by 0.4°C can be more finely divided by 0.2°C. The delay time can be determined by an arithmetic expression in which the temperature difference Δt serves as a coefficient without using the table as in FIG. 4.

### [Second Embodiment]

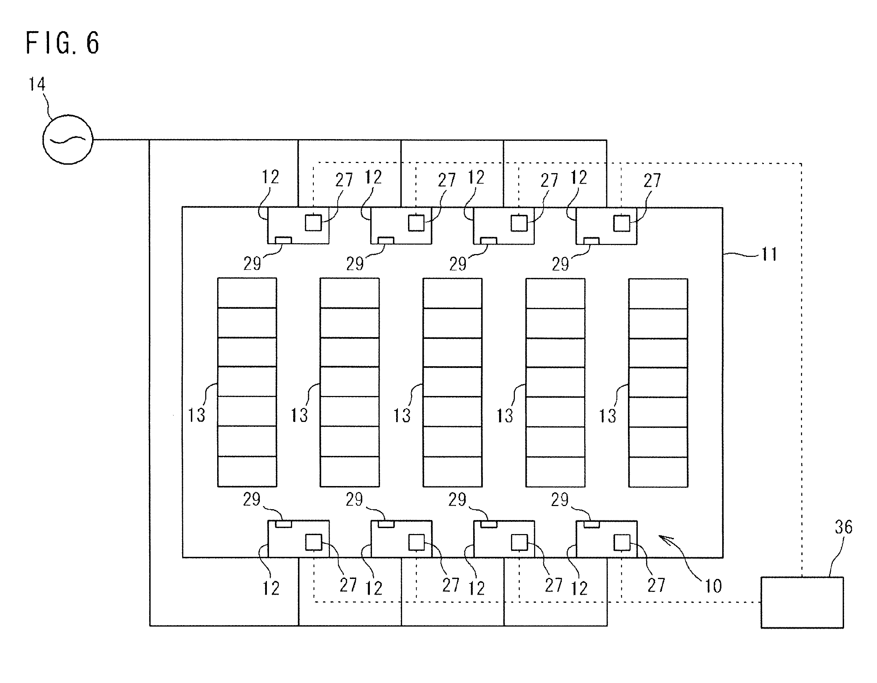

FIG. 6 is a schematic configuration diagram of an air conditioning system according to a second embodiment of the present invention.
An air conditioning system 10 of the present embodiment includes a central control device 36, and the central control device 36 is connected to control devices 27 of air conditioners 12 so as to communicate with the control devices. Further, the initiation timing setting function described in the first embodiment is provided in the central control device 36.

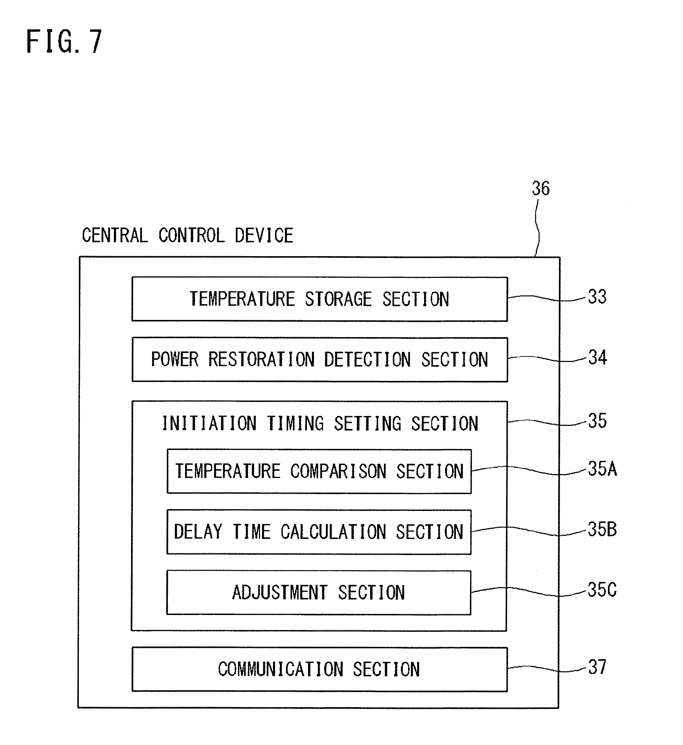

FIG. 7 is a block diagram showing a functional configuration of the central control device 36. The central control device 36 includes a temperature storage section 33, a power restoration detection section 34, and an initiation timing setting section 35 as well as the control device 27 of the first embodiment, and the functions of these sections are substantially the same as the first embodiment. An air conditioning temperature setting section 32 (refer to FIG. 3) described in the first embodiment is also provided in the present embodiment as a function of the control device 27 of the air conditioner 12. However, the air conditioning temperature setting section 32 may be provided as a function of the central control device 36.

As shown in FIG. 7, the central control device 36 is connected to an uninterruptible power supply system or an in-house power generator, so that the supply of the electric power is not interrupted even upon the power interruption.
Control temperatures set in the air conditioning temperature setting sections 32 of the air conditioners 12 are inputted and stored into the temperature storage section 33 via a communication section 37. Further, the interior temperatures detected by the temperature detection sensors 29 of the air conditioners 12 are also inputted and stored via the communication section 37.
In the initiation timing setting section 35, a difference between the control temperature and the interior temperature is determined in a temperature comparison section 35A, and a delay time is determined based on the temperature difference in a delay time calculation section 35B.

Although the present embodiment has substantially the same operation and effect as the first embodiment described above, the initiation timings of the air conditioners 12 are concentratedly managed in the central control device 36. Thus, for example, in a case where the initiation timings are overlapped between the plurality of air conditioners 12 as a result of determination of the delay times, adjustment for differentiating the initiation timings from each other (for example, further delaying one of the initiation timings by +0.5 seconds or the like) can be performed. Therefore, the central control device 36 may include an adjustment section 35C (refer to FIG. 7) for performing adjustment so as to differentiate the overlapped initiation timings from each other. Thereby, an increase in the peak current can be reliably suppressed, so that a burden applied to the power supply devices can be more reduced.

### [Third Embodiment]

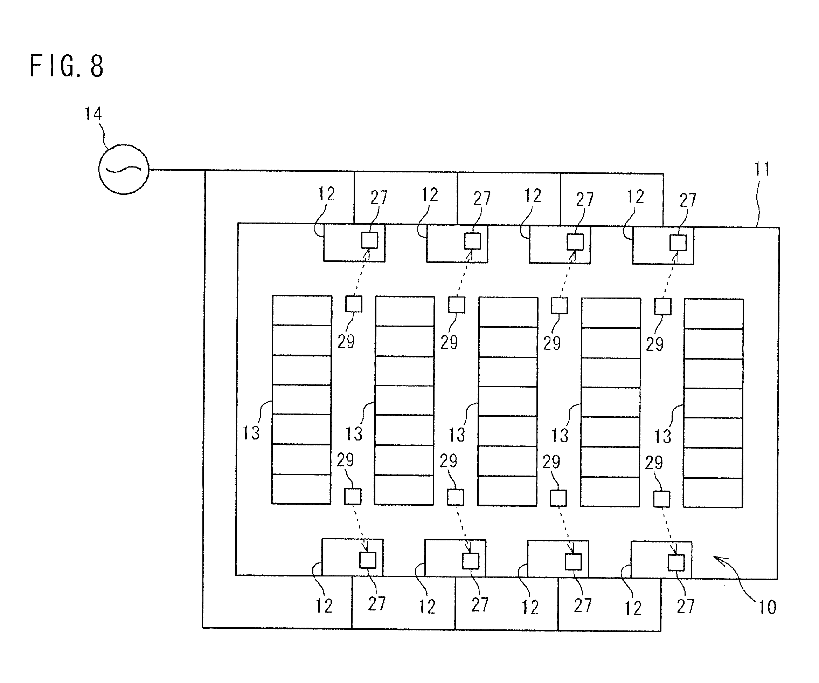

FIG. 8 is a schematic configuration diagram of an air conditioning system according to a third embodiment of the present invention.
In an air conditioning system 10 of the present embodiment, temperature detection sensors 29 used for the initiation timing setting are provided not in the air conditioners 12 but in an interior of a room 11, for example, at positions closer to racks 13 or the like. The plurality of temperature detection sensors 29 is respectively provided in regions which are influenced by air conditioning by the air conditioners 12, that is, in ranges of air conditioning regions corresponding to the air conditioners 12. Each of the temperature detection sensors 29 is connected to a control device 27 of the air conditioner 12 via a communication cable (not shown), and a detected interior temperature is inputted and stored into the control device 27.

In the present embodiment, the temperature detection sensor 29 is installed in a place closer to a computer device serving as a heating element, the place where a temperature change is remarkable. Thus, a temperature distribution in the interior (temperature variation) is precisely obtained, so that the initiation timing can be efficiently set.
It should be noted that in the present embodiment, a central control device 36 may also be provided as in the second embodiment, and the initiation timing of the air conditioner 12 may be set by the central control device 36.

The present invention is not limited to the above embodiments but can be appropriately changed within the scope of the invention described in the claims.
For example, the interior temperature compared with the control temperature by the temperature comparison section 35A of the initiation timing setting section 35 is the interior temperature when the power supply is restored in the above embodiments. However, the interior temperature can be an interior temperature immediately before the power interruption. The fact that a difference between the interior temperature immediately before the power interruption and the control temperature is large indicates that the relevant air conditioner 12 had been operated with a high ability until immediately before the power interruption. Thus, it can be said that an air conditioning load of the air conditioning region corresponding to the air conditioner 12 was high. Therefore, for such an air conditioning region, by promptly initiating the air conditioner 12 after the power restoration, the air conditioning ability can be promptly enhanced.

Although a case where the air conditioning system is installed in the data center is described in the above embodiments, the present invention is not limited to this. Further, the plurality of air conditioners is not necessarily installed in one room but may be separately installed in a plurality of rooms.

### REFERENCE SIGNS LIST

10: AIR CONDITIONING SYSTEM
12: AIR CONDITIONER
14: COMMERCIAL POWER SUPPLY
27: CONTROL DEVICE
29: TEMPERATURE DETECTION SENSOR
32: AIR CONDITIONING TEMPERATURE SETTING UNIT
33: TEMPERATURE STORAGE UNIT
34: POWER RESTORATION DETECTION UNIT
35: INITIATION TIMING SETTING UNIT
36: CENTRAL CONTROL DEVICE

## Claims

1. An air conditioning system comprising a plurality of air conditioners (12) to which electric power is supplied from the same power supply (14), the air conditioning system comprising:
temperature detection sensors (29) for respectively detecting interior temperatures in air conditioning regions corresponding to the air conditioners (12);
a temperature storage section (33) for storing control temperatures of the plurality of air conditioners (12) and the interior temperatures detected by the temperature detection sensors (29);
a power restoration detection section (34) for detecting that power supply is restored after power interruption; and
an initiation timing setting section (35) for, in a case where the power restoration is detected by the power restoration detection section (34), comparing the control temperatures stored in the temperature storage section (33) respectively for the plurality of air conditioners (12) with the interior temperatures detected after the power restoration or before the power interruption by the temperature detection sensors (29) and stored in the temperature storage section (33), and setting initiation timings of the air conditioners (12) in such a manner that the air conditioner (12) corresponding to the air conditioning region having a larger air conditioning load based on a difference between the temperatures is initiated earlier.

2. The air conditioning system according to claim 1, wherein the temperature detection sensor (29) is integrated with the air conditioner (12).

3. The air conditioning system according to claim 1, wherein the temperature detection sensor (29) is provided in the air conditioning region corresponding to the air conditioner (12) as a separate body from the air conditioner (12).

4. The air conditioning system according to any of claims 1 to 3, wherein the temperature storage section (33), the power restoration detection section (34), and the initiation timing setting section (35) are provided in each of the plurality of air conditioners (12).

5. The air conditioning system according to any of claims 1 to 3, further comprising: a central control device (36) having the temperature storage section (33), the power restoration detection section (34), and the initiation timing setting section (35), wherein the central control device (36) and the air conditioners (12) are connected so as to communicate with each other.

6. An initiation control method of an air conditioning system comprising a plurality of air conditioners (12) to which electric power is supplied from the same power supply (14), wherein
in a case where power supply is restored after power interruption, control temperatures of the air conditioners (12) are compared with interior temperatures after the power restoration or before the power interruption in air conditioning regions corresponding to the air conditioners (12), and the air conditioner (12) corresponding to the air conditioning region having a larger air conditioning load based on a difference between the temperatures is initiated earlier.
